# EUROPÄISCHE PATENTSCHRIFT

(11) **EP 1 458 103 B1**
(45) Veröffentlichungstag und Bekanntmachung des Hinweises auf die Patenterteilung: **15.07.2009**
(21) Anmeldenummer: 04014504.7
(22) Anmeldetag: 12.10.1998
(51) Int. Cl.: H03M 7/40

(54) **Verfahren und Vorrichtungen zum Codieren bzw. Decodieren eines Audiosignals bzw. eines Bitstroms**
Method and device for coding/decoding an audio signal
Méthode et dispositif de codage/décodage d'un signal audio

(30) Priorität: 24.10.1997 DE 19747119; 07.09.1998 DE 19840853
(43) Veröffentlichungstag der Anmeldung: 15.09.2004
(62) Teilanmeldung aus: 98119235.4
(73) Patentinhaber: Fraunhofer-Gesellschaft zur Förderung der angewandten Forschung e.V., 80686 München (DE)
(72) Erfinder: Sperschneider, Ralph, 91056 Erlangen (DE); Dietz, Martin, 90429 Nürnberg (DE); Ehret, Andreas, 90429 Nürnberg (DE); Brandenburg, Karlheinz, 91054 Erlangen (DE); Gerhäuser, Heinz, 91344 Waischenfeld (DE); Nowbakht-Irani, Ali, 5611 WE Eindhoven (NL); Lauber, Pierre, 90419 - Nürnberg (DE); Bitto, Roland, 90453 - Nürnberg (DE)
(74) Vertreter: Zinkler, Franz

(56) Entgegenhaltungen:
- EP-A2- 0 424 016
- EP-A2- 0 482 888
- EP-A2- 0 717 503
- JOHNSTON J D: "TRANSFORM CODING OF AUDIO SIGNALS USING PERCEPTUAL NOISE CRITERIA" IEEE JOURNAL ON SELECTED AREAS IN COMMUNICATIONS, IEEE SERVICE CENTER, PISCATAWAY, NJ, US, Bd. 6, Nr. 2, 1. Februar 1988 (1988-02-01), Seiten 314-323, XP002003779 ISSN: 0733-8716
- JEAN F-R ET AL: "Two-stage bit allocation algorithm for stereo audio coder" IEE PROCEEDINGS: VISION, IMAGE AND SIGNAL PROCESSING, INSTITUTION OF ELECTRICAL ENGINEERS, GB, Bd. 143, Nr. 5, 28. Oktober 1996 (1996-10-28), Seiten 331-336, XP006006860 ISSN: 1350-245X
- PERKINS C ET AL: "A SURVEY OF PACKET LOSS RECOVERY TECHNIQUES FOR STREAMING AUDIO" IEEE NETWORK, IEEE SERVICE CENTER, NEW YORK, NY, US, Bd. 12, Nr. 5, September 1998 (1998-09), Seiten 40-48, XP000875014 ISSN: 0890-8044

## Beschreibung

Die vorliegende Erfindung bezieht sich auf Verfahren und Vorrichtungen zum Codieren bzw. Decodieren eines Audiosignals bzw. eines Bitstroms, die eine fehlerrobuste Entropiecodierung bzw. -decodierung und insbesondere eine fehlerrobuste Huffman-Codierung bzw. -decodierung ausführen können.

Moderne Audiocodierverfahren bzw. -decodierverfahren, die beispielsweise nach dem Standard MPEG-Layer 3 arbeiten, sind in der Lage, die Datenrate von Audiosignalen beispielsweise um einen Faktor 12 zu komprimieren, ohne die Qualität derselben merkbar zu verschlechtern. Um eine derartig hohe Datenratenreduktion zu erreichen, wird ein Audiosignal abgetastet, wodurch eine Folge von zeitdiskreten Abtastwerten erhalten wird. Wie es in der Technik bekannt ist, wird diese Folge von zeitdiskreten Abtastwerten mittels geeigneter Fensterfunktionen gefenstert, um gefensterte Blöcke von zeitlichen Abtastwerten zu erhalten. Ein Block zeitlich gefensterter Abtastwerte wird dann mittels einer Filterbank, einer modifizierten diskreten Cosinustransformation (MDCT) oder einer anderen geeigneten Einrichtung in den Frequenzbereich transformiert, um Spektralwerte zu erhalten, die insgesamt das Audiosignal, d. h. den zeitlichen Ausschnitt, der durch den Block von zeitdiskreten Abtastwerten gegeben ist, im Frequenzbereich darstellen. Üblicherweise werden sich zu 50% überlappende zeitliche Blöcke erzeugt und mittels einer MDCT in den Frequenzbereich transformiert, wodurch aufgrund der speziellen Eigenschaften der MDCT immer beispielsweise 1024 zeitdiskrete Abtastwerte zu 1024 Spektralwerten führen.

Es ist bekannt, daß die Aufnahmefähigkeit des menschlichen Ohrs vom Augenblicksspektrum des Audiosignals selbst abhängt. Diese Abhängigkeit ist in dem sog. psychoakustischen Modell erfaßt, mittels dem es seit längerem möglich ist, abhängig vom augenblicklichen Spektrum Maskierungsschwellen zu berechnen. Maskierung bedeutet, daß ein bestimmter Ton bzw. Spektralanteil verdeckt wird, wenn beispielsweise ein benachbarter Spektralbereich eine relativ hohe Energie besitzt. Diese Tatsache der Maskierung wird ausgenutzt, um die nach der Transformation vorhandenen Spektralwerte möglichst grob zu quantisieren. Es wird daher angestrebt, einerseits hörbare Störungen im wieder decodierten Audiosignal zu vermeiden und andererseits möglichst wenig Bits zu verwenden, um das Audiosignal zu codieren bzw. hier zu quantisieren. Die durch die Quantisierung eingeführten Störungen, d. h. das Quantisierungsrauschen, soll unter der Maskierungsschwelle liegen und somit unhörbar sein. Gemäß bekannter Verfahren wird daher eine Einteilung der Spektralwerte in sog. Skalenfaktorbänder durchgeführt, die den Frequenzgruppen des menschlichen Ohrs entsprechen sollten. Spektralwerte in einer Skalenfaktorgruppe werden mit einem Skalenfaktor multipliziert, um Spektralwerte eines Skalenfaktorbandes insgesamt zu skalieren. Die durch den Skalenfaktor skalierten Skalenfaktorbänder werden anschließend quantisiert, woraufhin quantisierte Spektralwerte entstehen. Selbstverständlich ist eine Gruppierung in Skalenfaktorbänder nicht entscheidend. Sie wird jedoch bei den Standards MPEG-Layer 3 bzw. bei dem Standard MPEG-2 AAC (AAC = Advanced Audio Coding) verwendet.

Ein sehr wesentlicher Aspekt der Datenreduzierung besteht in der nach dem Quantisieren folgenden Entropie-Codierung der quantisierten Spektralwerte. Für die Entropiecodierung wird üblicherweise eine Huffman-Codierung verwendet. Unter einer Huffman-Codierung versteht man eine Codierung mit variabler Länge, d. h. die Länge des Codeworts für einen zu codierenden Wert ist abhängig von dessen Auftrittswahrscheinlichkeit. Logischerweise ordnet man dem wahrscheinlichsten Zeichen den kürzesten Code, d. h. das kürzeste Codewort, zu, so daß mit der Huffman-Codierung eine sehr gute Redundanzreduktion erreicht werden kann. Ein Beispiel für eine allseits bekannte Codierung mit variabler Länge ist das Morse-Alphabet.

In der Audiocodierung werden Huffman-Codes zur Codierung der quantisierten Spektralwerte benutzt. Ein moderner Audio-Coder, der beispielsweise nach dem Standard MPEG-2 AAC arbeitet, verwendet zur Codierung der quantisierten Spektralwerte verschiedene Huffman-Codetabellen, die dem Spektrum nach bestimmten Kriterien abschnittsweise zugeordnet werden. Dabei werden immer 2 oder 4 Spektralwerte in einem Codewort gemeinsam codiert.

Ein Unterschied des Verfahrens nach MPEG-2 AAC gegenüber dem Verfahren MPEG-Layer 3 besteht nun darin, daß verschiedene Skalenfaktorbänder, d. h. verschiedene Spektralwerte, zu beliebig vielen Spektralabschnitten oder "Sections" gruppiert werden. Bei AAC umfaßt ein Spektralabschnitt oder eine "Section" zumindest vier Spektralwerte aber vorzugsweise mehr als vier Spektralwerte. Der gesamte Frequenzbereich der Spektralwerte wird daher in benachbarte Sections aufgeteilt, wobei eine Section ein Frequenzband darstellt, derart, daß alle Sections zusammen den gesamten Frequenzbereich, der durch die Spektralwerte nach der Transformation derselben überdeckt wird, umfassen.

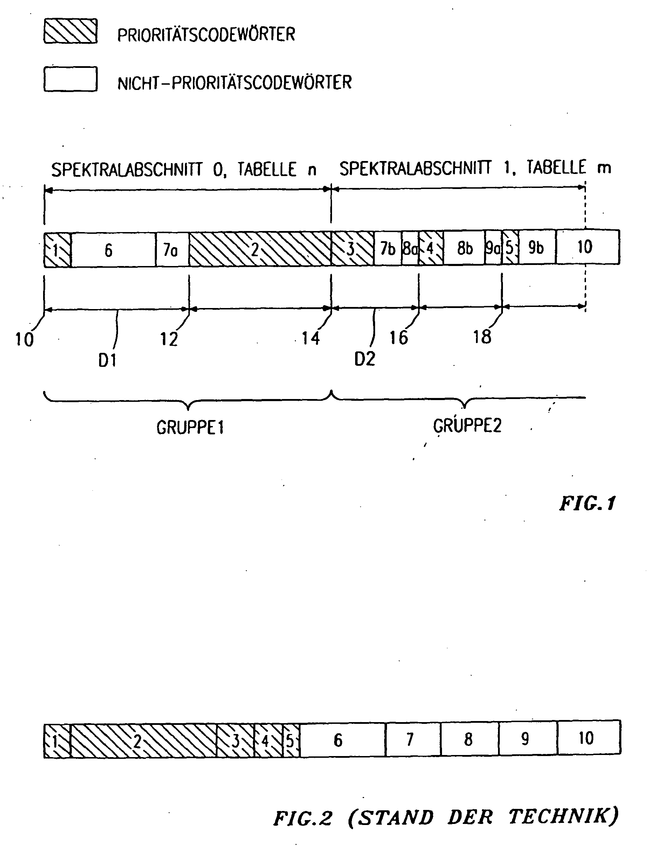

Einem Abschnitt wird nun ebenso wie beim MPEG-Layer-3-Verfahren zum Erreichen einer maximalen Redundanzreduktion eine sog. Huffman Tabelle aus einer Mehrzahl derartiger Tabellen zugeordnet. Im Bitstrom des AAC-Verfahrens, welches üblicherweise 1024 Spektralwerte aufweist, befinden sich nun die Huffman-Codewörter für die Spektralwerte in aufsteigender Frequenzreihenfolge. Die Information über die in jedem Frequenzabschnitt verwendete Tabelle wird in den Seiteninformationen übertragen. Diese Situation ist in Fig. 2 dargestellt.

Fig. 2 stellt den beispielhaften Fall dar, bei dem der Bitstrom 10 Huffman-Codewörter umfaßt. Wenn immer aus einem Spektralwert ein Codewort gebildet wird, so können hier 10 Spektralwerte codiert sein. Üblicherweise werden jedoch immer 2 oder 4 Spektralwerte durch ein Codewort gemeinsam codiert, weshalb Fig. 2 einen Teil des codierten Bitstroms darstellt, der 20 bzw. 40 Spektralwerte umfaßt. In dem Fall, in dem jedes Huffman-Codewort 2 Spektralwerte umfaßt, stellt das mit der Nr. 1 bezeichnete Codewort die ersten 2 Spektralwerte dar, wobei die Länge des Codeworts Nr. 1 relativ klein ist, was bedeutet, daß die Werte der beiden ersten Spektralwerte, d. h. der beiden niedrigsten Frequenzkoeffizienten, relativ häufig auftreten. Das Codewort mit der Nr. 2 hingegen besitzt eine relativ große Länge, was bedeutet, daß die Beträge des 3. und 4. Spektralkoeffizienten im codierten Audiosignal relativ selten sind, weshalb dieselben mit einer relativ großen Bitmenge codiert werden. Aus Fig. 2 ist ferner ersichtlich, daß die Codewörter mit den Nr. 3, 4 und 5, die die Spektralkoeffizienten 5 und 6, bzw. 7 und 8 bzw. 9 und 10 darstellen, ebenfalls relativ häufig auftreten, da die Länge der einzelnen Codewörter relativ gering ist. Ähnliches gilt für die Codewörter mit den Nr. 6 - 10.

Wie es bereits erwähnt wurde, ist es aus Fig. 2 deutlich ersichtlich, daß die Huffman-Codewörter für die codierten Spektralwerte bezüglich der Frequenz linear ansteigend im Bitstrom angeordnet sind, wenn ein Bitstrom betrachtet wird, der durch eine bekannte Codiervorrichtung erzeugt wird.

Ein großer Nachteil von Huffman-Codes im Falle fehlerbehafteter Kanäle ist die Fehlerfortplanzung. Es sei beispielsweise angenommen, daß das Codewort Nr. 2 in Fig. 2 gestört ist. Mit einer gewissen nicht niedrigen Wahrscheinlichkeit ist dann auch die Länge dieses falschen Codeworts Nr. 2 verändert. Dieselbe unterscheidet sich somit von der richtigen Länge. Wenn im Beispiel von Fig. 2 das Codewort Nr. 2 bezüglich seiner Länge durch eine Störung verändert worden ist, ist es für einen Codierer nicht mehr möglich, die Anfänge der Codewörter 3 - 10, d. h. fast des gesamten dargestellten Audiosignals, zu bestimmen. Es können also auch alle anderen Codewörter nach dem gestörten Codewort nicht mehr richtig decodiert werden, da nicht bekannt ist, wo diese Codewörter beginnen, und da ein falscher Startpunkt aufgrund des Fehlers gewählt wurde.

Das europäische Patent Nr. 0612156 schlägt als Lösung für das Problem der Fehlerfortpflanzung vor, einen Teil der Codewörter variabler Länge in einem Raster anzuordnen, und die restlichen Codewörter in die verbleibenden Lücken zu verteilen, so daß ohne vollständige Decodierung oder bei fehlerhafter Übertragung der Anfang eines Codeworts leichter gefunden werden kann.

Das bekannte Verfahren schafft für die Fehlerfortpflanzung eine teilweise Abhilfe durch Umsortierung der Codewörter. Für manche Codewörter wird ein fester Platz im Bitstrom vereinbart, während für die restlichen Codewörter die verbleibenden Zwischenräume zur Verfügung stehen. Dies kostet keine zusätzlichen Bits, verhindert aber im Fehlerfall die Fehlerfortpflanzung unter den umsortierten Codewörtern.

Entscheidender Parameter für die Effizienz des bekannten Verfahrens ist jedoch, wie das Raster in der praktischen Anwendung bestimmt wird, d. h. wie viele Rasterpunkte verwendet werden müssen, welchen Rasterabstand die Rasterpunkte haben, usw. Das europäische Patent 0612156 liefert jedoch neben dem allgemeinen Hinweis, ein Raster zur Eindämmung der Fehlerfortpflanzung zu verwenden, keine näheren Hinweise darauf, wie das Raster effizient gestaltet werden soll, um einerseits eine fehlerrobuste Codierung und andererseits auch eine effiziente Codierung zu ermöglichen.

Die EP 0 424 016 A2 offenbart ein Verfahren zum gehörangepassten Codieren von Audiosignalen. Eine Schätzung für die Maskierungsschwelle von Audiosignalen wird als Funktion der Frequenz bestimmt. Insbesondere wird ein Tonalitätsindex gebildet, der detaillierte Information liefert, die beim Bilden der Rauschmaskierungsfunktion nützlich sind. Beim Decodieren werden die spektralen Informationen des Audiosignals erhalten, und der Decodierer rekonstruiert eine gehörangepasste Darstellung des ursprünglichen Spektrums basierend auf übertragenen Seiteninformationen. Die Seiteninformationen können eine explizite Angabe der Quantisiererschrittweite oder Informationen sein, die sich auf die Art und Weise des Zuweisens von Bits beziehen. Andere Seiteninformationen, die sich auf die Fensterung, ein Pre-Echo, auf eine Skalierung und andere Parameter beziehen, können ebenfalls decodiert und verwendet werden, um codierte Spektralinformationen zu interpretieren.

Die Aufgabe der vorliegenden Erfindung besteht darin, ein Konzept zum fehlerrobusten und dennoch effizienten Decodieren eines Bitstroms zu schaffen.

Diese Aufgabe wird, durch ein Verfahren zum Decodieren eines Bitstroms gemäß Anspruch 6 oder durch eine Vorrichtung zum Decodieren eines Bitstroms gemäß Anspruch 1 gelöst.

Ausführungsbeispiele der vorliegenden Erfindung nutzen, daß das bereits vorgeschlagene Raster in bestimmter Weise ausgestaltet bzw. belegt ist, um neben einer fehlerrobusten Decodierung auch eine effiziente. Decodierung zu erreichen. Nützlich dabei ist, daß die Codewörter, die durch eine Entropiecodierung in Form einer Huffman-Codierung erhalten werden, inhärent eine unterschiedliche Länge haben, da der größte Codierungsgewinn erreicht wird, wenn einem zu codierenden Wert, der am häufigsten auftritt, ein möglichst kurzes. Codewort zugewiesen wird. Dagegen führt ein zu codierender Wert, der relativ selten auftritt, trotz eines relativ langen Codeworts, das demselben zugewiesen wird, zu einer statistisch gesehen optimalen Datenmenge. Codewörter, die durch eine Huffman-Codierung erhalten werden, weisen also an sich unterschiedliche Längen auf.

Gemäß einem Ausführungsbeispiel werden an den Rasterpunkten sog. Prioritätscodewörter plaziert, derart, daß trotz eines möglichen Fehlers im Bitstrom aufgrund des Rasters immer der Anfang der Prioritätscodewörter von einem Decodierer sicher festgestellt werden kann. Unter Prioritätscodewörtern sind Codewörter zu verstehen, die psychoakustisch bedeutsam sind. Dies bedeutet, daß die Spektralwerte, die durch sog. Prioritätscodewörter codiert sind, wesentlich zum Höreindruck eines decodierten Audiosignals beitragen. Wenn das Audiosignal beispielsweise einen großen Anteil an Sprache aufweist, so könnten die Prioritätscodewörter die Codewörter sein, die eher niedrigere Spektralwerte darstellen, da die wesentlichen Spektralinformationen in diesem Falle im niedrigen Spektralbereich auftreten. Wenn an ein Audiosignal gedacht wird, das eine Gruppe von Tönen im mittleren Frequenzbereich aufweist, so könnten die Prioritätscodewörter die Codewörter sein, die den Spektralwerten in dem entsprechenden mittleren Frequenzbereich zugeordnet sind, da dieselben dann die psychoakustisch bedeutsamen Spektralwerte sind. Psychoakustisch bedeutsame Spektralwerte könnten auch Spektralwerte sein, die im Vergleich zu anderen Spektralwerten im Spektrum einen großen Betrag, d. h. eine große Signalenergie, umfassen. Psychoakustisch weniger bedeutsame Codewörter, die auch als Nicht-Prioritätscodewörter bezeichnet werden, füllen dagegen das Raster auf. Sie werden also nicht mit Rasterpunkten ausgerichtet, sondern in den noch freien Plätzen nach dem Positionieren der Prioritätscodewörter auf die Rasterpunkte "einsortiert".

Gemäß dem Ausführungsbeispiel werden somit die Prioritätscodewörter, die Spektralwerten zugeordnet sind, welche psychoakustisch bedeutsam sind, in einem Raster derart angeordnet, daß der Anfang der Prioritätscodewörter mit den Rasterpunkten zusammenfällt.

Gemäß einem weiteren Ausführungsbeispiel wird eine Gruppierung der Spektralwerte in Spektralabschnitte durchgeführt, wobei jedem Spektralabschnitt eine andere Codetabelle zugeordnet wird. Die Zuordnung einer Codetabelle zu einem Spektralabschnitt beruht auf signalstatistischen Aspekten, d. h. welche Codetabelle optimal zur Codierung eines Spektralabschnitts geeignet ist, wobei die Zuordnung einer Codetabelle zu einem Spektralabschnitt in der Technik bereits bekannt ist.

Es wird nun ein Raster verwendet, welches mehrere Gruppen von in sich äquidistanten Rasterpunkten aufweist, derart, daß der Abstand der Rasterpunkte einer Gruppe von Rasterpunkten von der Codetabelle abhängt, die zur Codierung eines Spektralabschnitts verwendet wird. In einem anderen Spektralabschnitt wird eine andere Codetabelle verwendet, um eine optimale Datenreduktion zu erreichen. Der anderen Codetabelle ist wiederum eine andere Gruppe von äquidistanten Rasterpunkten zugeordnet, wobei der Abstand zwischen zwei Rasterpunkten dieser anderen Gruppen von Rasterpunkten von der entsprechenden weiteren Codetabelle abhängt. Die Abhängigkeit des Abstands zweier Rasterpunkte in den verschiedenen Gruppen von Rasterpunkten kann zumindest auf drei verschiedene Arten und Weisen bestimmt werden.

Zum einen wird die maximale Länge eines Codeworts einer Codetabelle ermittelt. Der Abstand zweier Rasterpunkte in der Rasterpunktgruppe, die dieser Codetabelle zugeordnet ist, kann nun gleich oder größer als die maximale Codewortlänge in der Codetabelle gewählt werden, derart, daß auch das längste Codewort dieser Codetabelle in dem Raster Platz hat. Analog dazu wird der Abstand zweier Rasterpunkte einer anderen Gruppe von Rasterpunkten, die wiederum einer anderen Codetabelle entspricht, gemäß der maximalen Codewortlänge dieser anderen Codetabelle bestimmt.

Die zweite Alternative, die nachfolgend beschrieben ist, kann ebenfalls zu einer Erhöhung der Anzahl der Rasterpunkte beitragen. Aufgrund der inhärenten Eigenschaften des Huffman-Codes sind seltener auftretende Codewörter eher länger als häufiger auftretende Codewörter. Wenn daher der Rasterpunktabstand gleich oder größer als die Länge des Codeworts mit maximaler Länge einer Tabelle gewählt wird, so werden meistens Codewörter ins Raster eingefügt, die kürzer als der Rasterpunktabstand sind. Der Rasterpunktabstand kann daher auch kleiner als die Länge des längsten Codeworts einer Tabelle gewählt werden. Falls dann beim Codieren ein Codewort auftritt, das nicht ins Raster paßt, so wird der nicht ins Raster passende Rest an einer anderen geeigneten Stelle nicht mit dem Raster ausgerichtet in den Bitstrom eingetragen. Dies führt dazu, daß dieses "zerstückelte" Codewort nicht mehr wirksam vor einer Fehlerfortpflanzung geschützt ist. Da dasselbe jedoch sehr selten auftritt, kann dies im Interesse einer Erhöhung der Anzahl der Rasterpunkte in Kauf genommen werden.

Eine weitere Möglichkeit zum Bestimmen der unterschiedlichen Rasterpunktabstände besteht darin, nicht die maximale Codewortlänge einer Tabelle zu berücksichtigen, sondern die Länge des längsten tatsächlich auftretenden Codeworts im Bitstrom in einem codierten Spektralabschnitt zu verwenden.

Gemäß einem weiteren Ausführungsbeispiel kann anstelle einer im wesentlichen linear mit der Frequenz ansteigenden Anordnung der Codewörter im Bitstrom ein frequenzmäßig verteiltes Anordnen der Codewörter verwendet werden, wobei dieses Verfahren auch als "Scramblen" bezeichnet wird. Dies hat den Vorteil, daß sog. "Burst"-Fehler nicht zu einer fehlerhaften Decodierung eines kompletten Frequenzbandes führt, sondern nur kleine Störungen in mehreren verschiedenen Frequenzbereichen erzeugen.

Gemäß einem weiteren Ausführungsbeispiel kann ferner anstelle einer linear mit der Frequenz ansteigenden Anordnung der Codewörter auch eine Anordnung verwendet werden, bei der z. B. nur jedes n-te Codewort (z. B. jedes 2. oder jedes 3. oder jedes 4., ...) im Raster angeordnet wird. Dadurch wird es möglich, durch Prioritätscodewörter einen möglichst großen Spektralbereich zu überdecken, d. h. gegen eine Fehlerfortpflanzung zu schützen, wenn die Anzahl der möglichen Rasterpunkte kleiner als die Anzahl der Prioritätscodewörter ist.

Ferner wird es bevorzugt, daß die Prioritätscodewörter auf eine bestimmte Art und Weise bestimmt werden, damit ein effizienter Betrieb erreicht wird. Daher wird bevorzugterweise von der Annahme Abschied genommen, daß die psychoakustisch bedeutsamen Codewörter, d. h. Prioritätscodewörter, die sind, die Spektralwerte mit niedriger Frequenz codieren. Dies wird sehr oft zutreffen, muß jedoch nicht immer der Fall sein.

Normalerweise sind Prioritätscodewörter Codewörter, die psychoakustisch bedeutsame Spektrallinien codieren, welche üblicherweise Spektralwerte mit hoher Energie sind. Genauso wichtig ist es, daß Spektrallinien mit hoher Energie nicht aufgrund von Fehlern auftreten.

So kann ein Indikator verwendet werden, der bereits implizit gegeben ist. Der Indikator hängt von der verwendeten Codetabelle ab. Beim AAC-Standard existieren beispielsweise elf Codetabellen, die voneinander unterschiedliche absolute Wertebereiche haben. Die Codetabelle Nr. 1 umfaßt z. B. Spektralwerte mit einem Absolutwert von -1 bis +1, während die Codetabelle Nr. 11 Spektralwerte von -8191 bis +8191 codieren kann. Je höher die Codetabelle ist, umso größer ist auch der durch dieselbe erlaubte Wertebereich. Dies bedeutet, daß Codetabellen mit niedrigen, Nummern nur relativ kleine Werte darstellen und daher nur relativ kleine Fehler erlauben, während Codetabellen mit höheren Nummern relativ große Werte darstellen können und daher ebenfalls relativ große Fehler erlauben.

Tritt in einer niedrigen Codetabelle ein Fehler auf, so wird derselbe unter Umständen gar nicht hörbar sein, da eine fehlerhafte Spektrallinie entsteht, die sich absolut gesehen nicht so stark von der ursprünglich korrekten Spektrallinie unterscheidet. Tritt jedoch in der höchsten Codetabelle ein Fehler auf, so kann dieser Fehler prinzipiell alle möglichen Absolutwerte in dieser Codetabelle annehmen. Wenn eine mit der höchsten Codetabelle codierte Spektrallinie beispielsweise einen geringen Wert hatte und durch einen Fehler während der Übertragung im Decodierer als Spektrallinie decodiert wird, die den höchsten absoluten Wert dieser Codetabelle hat, so wird diese fehlerhafte Spektrallinie sicherlich hörbar sein.

Bezüglich Fehlerrobustheit ist die wichtigste Codetabelle daher die höchste Codetabelle (beim AAC-Standard die Codetabelle Nr. 11), da diese Codetabelle Escape-Werte mit einem Bereich zwischen -2¹³ + 1 (-8191) und +2¹³ - 1 (+8191) zuläßt.

Gemäß einem weiteren Ausführungsbeispiel werden beim AAC-Standard kurze Fenster bei transienten Signalen verwendet. Bei kurzen Fenstern wird die Frequenzauflösung zugunsten einer höheren zeitlichen Auflösung verringert. Eine Bestimmung der Prioritätscodewörter wird dahingehend durchgeführt, daß mit Sicherheit psychoakustisch bedeutsame Spektralwerte, d. h. Spektralwerte bei niedrigeren Frequenzen oder Spektralwerte aus höheren Codetabellen, auf Rasterpunkte plaziert werden. Eine z. B. beim AAC-Standard durchgeführte skalenfaktorbandweise Verschachtelung wird dafür aufgehoben.

Bevorzugte Ausführungsbeispiele der vorliegenden Erfindung werden nachfolgend bezugnehmend auf die beiliegenden Zeichnungen detaillierter erörtert. Es zeigen:
- Fig. 1: ein Beispiel für eine Rasterung eines codierten Bitstroms, der Codewörter enthält, gemäß einem Ausführungsbeispiel ; und
- Fig. 2: eine linear mit der Frequenz ansteigende Anordnung von Codewörtern gemäß dem Stand der Technik.

Zur Erläuterung der vorliegenden Erfindung sind in Fig. 2, die eine bekannte linear mit der Frequenz ansteigende Anordnung von Codewörtern unterschiedlicher Länge darstellt, Prioritätscodewörter schraffiert dargestellt. In Fig. 2 sind Prioritätscodewörter die Codewörter Nr. 1 - Nr. 5. Wie es bereits oben erwähnt wurde, sind die Codewörter, welche frequenzmäßig niedrigen Spektralwerten zugeordnet sind, dann Prioritätscodewörter, wenn das Audiosignal beispielsweise einen hohen Sprachanteil enthält, oder relativ viele Töne, welche niederfrequent sind. Die Codewörter Nr. 6 - 10 in Fig. 2 beziehen sich auf höherfrequentere Spektralwerte, welche zwar zum Gesamteindruck des decodierten Audiosignals sehr wohl beitragen, welche jedoch keine wesentlichen Auswirkungen auf den Höreindruck haben und somit psychoakustisch weniger bedeutsam sind.

Fig. 1 zeigt nun einen Bitstrom, der eine Anzahl von Rasterpunkten 10 - 18 aufweist, wobei der Abstand zwischen dem Rasterpunkt 10 und dem Rasterpunkt 12 als D1 bezeichnet ist, während der Abstand zwischen dem Rasterpunkt 14 und dem Rasterpunkt 16 als D2 bezeichnet wird.

Bezüglich der Darstellung eines Ausführungsbeispiels sei lediglich der Teil des Bitstroms betrachtet, der sich vom Rasterpunkt 10 bis zum Rasterpunkt 14 erstreckt. Die Prioritätscodewörter 1 und 2 werden nun im Raster ausgerichtet, damit sichergestellt ist, daß die wesentlichen Spektralanteile, die sich bei dem in Fig. 2 dargestellten Beispielsignal im unteren Frequenzbereich befinden, bei einer Codierung keiner Fehlerfortpflanzung unterworfen werden. Nicht-Prioritätscodewörter, welche in den Fig. nicht schraffiert sind, werden nach den Prioritätscodewörtern angeordnet, um das Raster auszufüllen. Es ist nicht erforderlich, daß die Nicht-Prioritätscodewörter am Stück in das Raster passen, da sich die Länge eines Huffman-Codeworts aus sich selbst ergibt. Ein Decodierer weiß also, ob er nur den Teil eines Codeworts eingelesen hat. In diesem Falle wird er automatisch eine bestimmte Anzahl von Bits nach dem Prioritätscodewort hinter dem nächsten Rasterpunkt dem ersten Codewortstück hinzufügen. Es ist somit möglich, einen ersten Teil eines Nicht-Prioritätscodeworts in einer ersten noch freien Position im Raster einzufügen, und den restlichen Teil desselben an einer anderen Stelle, wie es beispielsweise durch die Nicht-Prioritätscodewörter 7, 8 und 9 dargestellt ist, welche im Bitstrom jeweils zweigeteilt worden sind, d. h. 7a, 7b bzw. 8a, 8b bzw. 9a, 9b.

Wie bereits dargestellt wurde, bezieht sich der 2. Teil des Bitstroms von Fig. 1 bereits auf ein anderes Ausführungsbeispiel. Würde der Rasterabstand D1 nicht zu einem kleineren Rasterabstand D2 verändert werden, so würde ein Raster mit dem Abstand D1, in dem alle Prioritätscodewörter 1 bis 5 angeordnet werden sollen, zu einem derart langen Bitstrom führen, daß sozusagen nicht genug Nicht-Prioritätscodewörter vorhanden sind, um alle im Raster verbleibenden Lücken aufzufüllen. Es werden daher aus einem Audiosignal nur so viel Prioritätscodewörter extrahiert, wie im Bitstrom eingesetzt werden können, damit im wesentlichen keine freien Stellen zurückbleiben, d. h. damit der Bitstrom nicht unnötig verlängert wird.

Anschließend wird bezugnehmend auf Fig. 1 auf das andere Ausführungsbeispiel detailliert eingegangen. Im Falle des Codierverfahrens nach dem Standard MPEG-2 AAC können 11 verschiedene Huffman-Codetabellen zur Codierung verwendet werden. Für die meisten dieser Tabellen beträgt die maximal mögliche Codewortlänge zwischen 10 und 20 Bit. Eine spezielle Tabelle, die sog. "Escape"-Tabelle, umfaßt jedoch eine Länge von maximal 49 Bit. Würde man hier als Rasterabstand D die Länge des längsten Codeworts aller Tabellen verwenden, so erhielte man einen Rasterabstand von 49 Bit, was zu einem Raster mit sehr großer Breite führt und daher für fast alle Tabellen ineffizient ist, da der Bitstrom viel zu lang werden würde, wenn alle Prioritätscodewörter mit einem Rasterpunkt ausgerichtet werden sollen. Erfindungsgemäß wird daher die Breite des Rasters in Abhängigkeit der benutzten Codetabelle eingestellt. Wie bereits eingangs erwähnt wurde, können Spektralwerte in Spektralabschnitte gruppiert werden, wobei dann unter Berücksichtigung signalstatistischer Aspekte jedem Spektralabschnitt eine für denselben optimale Codetabelle zugeordnet wird. Die maximale Codewortlänge in einer Codetabelle unterscheidet sich jedoch zumeist von der maximalen Codewortlänge einer anderen Tabelle.

So sei angenommen, daß die Spektralwerte, die durch die Codewörter 1 und 2 dargestellt werden, zu einem ersten Spektralabschnitt gehören, während die Spektralwerte, die durch die Codewörter 3 - 10 dargestellt sind, zu einem zweiten Spektralabschnitt gehören. Der Bitstrom wird nun gerastert, indem 2 Gruppen von Rasterpunkten verwendet werden, wobei die 1. Gruppe von Rasterpunkten die Rasterpunkte 10, 12 und 14 aufweist, während die 2. Gruppe von Rasterpunkten die Rasterpunkte 14, 16 und 18 aufweist. Ferner sei angenommen, daß dem Spektralabschnitt 0 die Huffman-Codetabelle n zugewiesen wurde, während dem Spektralabschnitt 1 die Huffman-Codetabelle m zugeordnet wurde. Außerdem sei angenommen, daß das Codewort 2 das längste Codewort der Tabelle n ist, die dem Spektralabschnitt 0 zugeordnet wurde. Der Rasterabstand der 1. Gruppe von Rasterpunkten wird größer oder vorzugsweise gleich der maximalen Länge des Codeworts der Tabelle n, im Beispiel also des Codeworts Nr. 2, eingestellt.

Der Abschnitt des Bitstroms zwischen dem Rasterpunkt 14 und dem Ende des Bitstroms am Codewort Nr. 10 zeigt dagegen, daß in diesem gewählten Beispiel das Codewort mit der maximalen Länge der Codetabelle m im Bitstrom nicht auftritt. In dem Bitstromraster, das durch die Gruppe 2 bezeichnet ist, existiert also kein Codewort, das eine Länge D2 aufweist.

Gemäß diesem Ausführungsbeispiel wird die Breite des Rasters also abhängig von der benutzten Codetabelle eingestellt. Es sei darauf hingewiesen, daß in diesem Fall jedoch die verwendete Tabelle im Decodierer zur Decodierung bereits bekannt sein muß. Dies ist jedoch der Fall, da als Seiteninformationen ohnehin für jeden Spektralabschnitt eine Codetabellennummer übertragen wird, mittels der ein Decodierer die verwendete Codetabelle aus einem vorgegebenen Satz von in diesem Beispiel 11 verschiedenen Huffman-Tabellen identifizieren kann.

Wie es bereits angesprochen wurde, ist bei einer Abhängigkeit des Rasterabstands von der verwendeten Codetabelle besonders wenn an die Escape-Tabelle, dessen längstes Codewort eine Länge von 49 Bit hat, gedacht wird, noch immer keine optimale Datenreduktion zu erreichen, da im Falle einer Escape-Tabelle die Rasterbreite auf 49 Bit eingestellt wird, um maximal große Spektralwerte zu codieren. Escape-Tabellen werden eingesetzt, um zum einen relativ kurze Codetabellen zu haben, um jedoch zum anderen relativ große Werte mittels der kurzen Codetabellen in Verbindung mit einer Escape-Tabelle codieren zu können. Im Falle eines Werts, der den Wertebereich einer Codetabelle übersteigt, nimmt das Codewort für diesen Spektralwert einen vorbestimmten Wert an, der dem Decodierer signalisiert, daß zusätzlich eine Escape-Tabelle im Codierer verwendet worden ist. Umfaßt eine Codetabelle beispielsweise die Werte von 0 - 2, so würde ein Wert von 3 in der Codetabelle dem Decodierer signalisieren, daß auf eine Escape-Tabelle zurückgegriffen wird. Dem Codewort mit dem Wert 3 der "Grund"-Codetabelle wird gleichzeitig ein Wert der Escape-Tabelle zugeordnet, welcher zusammen mit dem maximalen Wert der Grund-Codetabelle den entsprechenden Spektralwert ergibt.

Gemäß einem weiteren Ausführungsbeispiel der vorliegenden Erfindung wird der Abstand der Rasterpunkte einer Gruppe (beispielsweise der Gruppe 1 oder der Gruppe 2) nicht mehr gleich der Länge des längsten Codeworts einer Codetabelle eingestellt, sondern gleich der Länge des längsten tatsächlich auftretenden Codeworts in einem Bitstrom, der zu einer Codetabelle gehört. Dies stellt eine weitere Verbesserung gegenüber den vorherigen Ausführungsbeispiel dar, da auch trotz dieses Verfahrens die Codiereffizienz bei der Escape-Tabelle immer noch nicht optimal ist. Aus codiertechnischen Gründen ist die Maximallänge des Codes dieser Tabelle (innerhalb eines Spektrums) meist wesentlich geringer. Das längste Codewort in der Escape-Tabelle ist beispielsweise 49 Bit lang.

Das längste bei üblichen Audiosignalen tatsächlich auftretende Codewort der Escape-Tabelle ist typischerweise etwa 20 Bit lang. Es ist daher möglich, die Zahl der Rasterpunkte und damit die Zahl der Prioritätscodewörter, die mit den Rasterpunkten ausgerichtet werden können, weiter zu erhöhen, indem zusätzlich die Länge des längsten Codeworts eines Blocks übertragen wird. Die Rasterlänge ergibt sich dann aus dem Minimum aus der tatsächlich auftretenden maximalen Codewortlänge und der theoretisch maximalen Codewortlänge der gerade verwendeten Tabelle. Für die Bestimmung des Minimums ist es möglich, das tatsächlich auftretende Codewort jeder Codetabelle in einem Audioframe oder lediglich das tatsächlich längste Codewort aller Codetabellen in einem Audioframe zu verwenden. Diese Option arbeitet auch für Nicht-Escape-Tabellen, also für "Grund"-Huffman-Tabellen, jedoch bei weitem nicht so effizient wie für die Escape-Tabellen.

Die Übertragung der Maximallänge eines Codeworts in einem Spektralabschnitt oder Block gemäß der vorliegenden Erfindung hat einen günstigen Nebeneffekt. Der Decodierer kann erfindungsgemäß aufgrund der maximalen tatsächlich aufgetretenen Länge erkennen, ob in einem unter Umständen gestörten Bitstrom ein längeres Codewort vorhanden ist. Lange Codewörter bedeuten üblicherweise eine hohe Energie der Spektralwerte. Wenn durch einen Übertragungsfehler ein sehr langes Codewort zustande kommt, können außerordentlich hörbare Störungen entstehen. Die Übertragung der Maximallänge ermöglicht somit in den meisten Fällen erfindungsgemäße eine Detektion eines solchen Fehlers und somit Gegenmaßnahmen, welche beispielsweise einfach ein Ausblenden dieses zu langen Codeworts sind, oder eine kompliziertere Verschleierungsmaßnahme.

An dieser Stelle sei angemerkt, daß für eine möglichst fehlerrobuste und dennoch effiziente Codierung möglichst viele Rasterpunkte erwünscht sind. Die Anzahl der Rasterpunkte nach oben ist jedoch durch die insgesamte Länge des Bitstroms begrenzt. Diese sollte natürlich durch die Rasterung nicht vergrößert werden, da dann unbenutzte Stellen im Bitstrom vorhanden sein würden, welche der Philosophie der gesamten Datenkompression widersprechen würden. Dennoch sei darauf hingewiesen, daß zugunsten einer hohen Fehlerrobustheit in bestimmten Anwendungsfällen sehr wohl eine Verlängerung des Bitstroms in Kauf genommen werden kann. Andererseits ist es wünschenswert, ein Raster derart anzuordnen, daß möglichst viele Codewörter an Rasterpunkten beginnen. Ausführungsbeispiele erlauben somit wirksam im Gegensatz zum Stand der Technik eine Flexibilisierung des Rasterpunktabstandes. Die Flexibilisierung würde im absolut idealen Fall dazu führen, im wesentlichen jedem Codewort einen Rasterpunkt zuzuordnen, was selbstverständlich nur mit erheblichem Aufwand möglich ist. Die Anordnung der Rasterpunkte, d. h. die Bestimmung der Rasterpunktabstände in Abhängigkeit von den Codetabellen für jeden Spektralabschnitt erlaubt jedoch eine sehr effiziente Annäherung an den Optimalzustand, zumal bei weitem nicht alle Codewörter psychoakustisch bedeutsam sind, und zumal auch alle psychoakustisch weniger bedeutsamen Codewörter ebenfalls in den Bitstrom zwischen die rastermäßig angeordneten psychoakustisch bedeutsamen Codewörter sozusagen einsortiert werden sollten, damit keine unbenutzten Stellen im Bitstrom erhalten werden.

Gemäß einem weiteren Ausführungsbeispiel wird von der linear mit der Frequenz steigenden Anordnung im Bitstrom weggegangen, und die Codewörter für verschiedene Spektralwerte werden "gescrambelt". Wenn Fig. 1 betrachtet wird, so ist eine gewissermaßen verschachtelte lineare Anordnung der Codewörter mit der Frequenz zu sehen, da die schraffierten Prioritätscodewörter in aufsteigender Frequenzrichtung angeordnet sind, und da die Nicht-Prioritätscodewörter, die nicht schraffiert sind, ebenfalls in aufsteigender Frequenzreihenfolge im Bitstrom einsortiert sind. Würde nun bei dem in Fig. 1 dargestellten Bitstrom ein sog. "Burst"-Fehler auftreten, d. h. eine Störung, die zur Beschädigung mehrerer aufeinanderfolgender Codewörter führt, so würden beispielsweise die Codewörter 6, 7a, 2, 3 und 7b gleichzeitig zerstört werden.

In dem entsprechenden decodierten Audiosignal würde in dem durch die Prioritätscodewörter 2 und 3 dargestellten Spektralband eine spektralmäßig gesehen relativ breite Störung und damit eher deutlicher hörbare Störung auftreten. Das Problem der Burst-Fehler ist aus dem sehr einfachen Beispiel in Fig. 1 nicht besonders deutlich zu sehen. In der Praxis ist jedoch davon auszugehen, daß viel mehr als fünf Rasterpunkte vorhanden sein werden, wobei sich Burst-Fehler oft über mehrere Rasterpunkte hinweg erstrecken, was zu einem Verlust an Daten für ein relativ breites Frequenzband führen kann. Daher werden gemäß dem weiteren Ausführungsbeispiel vorzugsweise die Prioritätscodewörter und optional dazu auch die Nicht-Prioritätscodewörter für die Spektralwerte nicht mehr in aufsteigender Frequenzreihenfolge sondern "gemischt" angeordnet, derart, daß dieselben eine zufällige oder pseudozufällige frequenzmäßige Anordnung haben. Bei einer pseudozufälligen Anordnung müssen keine Informationen bezüglich der Verteilung als Seiteninformationen übertragen werden, da diese Verteilung im Decodierer a priori fest eingestellt werden kann. Dies würde dann dazu führen, daß ein Verlust von im Bitstrom benachbarten Codewörtern nicht zu einem Verlust eines vollständigen Frequenzbands führt, sondern nur zu einem sehr kleinen Verlust in mehreren Frequenzbändern. Diese Störung dürfte kaum hörbar sein und könnte auch effizienter verschleiert werden als ein Verlust eines gesamten Frequenzbands.

Gemäß einem weiteren Ausführungsbeispiel ist statt einer linear mit der Frequenz ansteigenden Anordnung der Prioritätscodewörter bzw. der Nicht-Prioritätscodewörter eine Anordnung möglich, die nur z. B. jedes n-te Codewort im Raster anordnet und die restlichen Codewörter dazwischen einsortiert. Wie es bereits erwähnt wurde, ist die Anzahl der Rasterpunkte für einen Bitstrom durch die insgesamte Länge und den gewählten Rasterpunktabstand begrenzt. Wenn beispielsweise an eine Abtastung mit niedriger Bandbreite gedacht wird, so kann der Fall auftreten, daß von den Codewörtern die allermeisten psychoakustisch bedeutsame Codewörter sind, da das gesamte Signal eine theoretisch mögliche Nutzbandbreite von 8 kHz hat, wenn eine Abtastrate von 16 kHz verwendet wird. Erfahrungsgemäß können nur 30% der Codewörter an Rasterpunkten angeordnet werden, wobei die restlichen 70% verwendet werden müssen, um das Raster vollends aufzufüllen. Dies würde jedoch bedeuten, daß nicht der gesamte wichtige Frequenzbereich bei Sprachsignalen beispielsweise der Bereich von 0 - 4 kHz mit Prioritätscodewörtern, die an Rasterpunkten angeordnet sind, abgedeckt bzw. "geschützt" werden kann. Um dennoch für den wichtigen Frequenzbereich einen ausreichenden Schutz vor Fehlerfortpflanzungen zu erreichen, wird daher nicht mehr jedes Prioritätscodewort sondern lediglich jedes 2., 3. oder 4. usw. mit einem Rasterpunkt ausgerichtet, während die dazwischenliegenden Prioritätscodewörter nicht mit Rasterpunkten ausgerichtet werden, sondern das Raster auffüllen. Wenn beispielsweise im niedrigen Frequenzbereich jeder 2. Spektralwert bzw. jeder 3. usw. bekannt ist, so können die dazwischenliegenden Codewörter, wenn sie bei einer Übertragung beschädigt werden, im Decodierer unter Umständen durch Fehlerverschleierungstechniken, wie z. B. eine Prädiktion o. ä., wiederhergestellt werden.

Die Verfahren bzw. Vorrichtungen zum Decodieren eines Bitstroms arbeiten im wesentlichen spiegelbildlich zu der beschriebenen Codierung.

Bei einem allgemeinen Verfahren zum Decodieren eines Bitstroms, der ein codiertes Audiosignal darstellt, wobei der codierte Bitstrom Codewörter mit unterschiedlicher Länge aus einer Codetabelle und ein Raster mit äquidistanten Rasterpunkten (10, 12, 14) aufweist, wobei die Codewörter Prioritätscodewörter aufweisen, die bestimmte Spektralwerte darstellen, die im Vergleich zu anderen Spektralwerten psychoakustisch bedeutsam sind, und wobei Prioritätscodewörter mit Rasterpunkten ausgerichtet sind, wird (a) der Abstand D1 zwischen zwei benachbarten Rasterpunkten erfaßt. Wenn der Abstand zwischen zwei Rasterpunkten bekannt ist, können (b) die mit den Rasterpunkten ausgerichteten Prioritätscodewörter in dem codierten Bitstrom umsortiert werden, derart, daß eine frequenzmäßig lineare Anordnung derselben erhalten wird, wobei der Beginn eines Prioritätscodeworts mit einem Rasterpunkt zusammenfällt. Nun liegen die Prioritätscodewörter wieder in der in Fig. 2 gezeigten allgemein frequenzlinearen Anordnung vor, womit (c) die Prioritätscodewörter mit einer Codetabelle, der dieselben angehören, wieder decodiert werden können, um decodierte Spektralwerte zu erhalten. Nach einer (d) Rücktransformation der decodierten Spektralwerte in den Zeitbereich liegt ein decodiertes Audiosignal vor, das auf bekannte Art und Weise verarbeitet werden kann, um beispielsweise einem Lautsprecher zugeführt zu werden.

Ist der Bitstrom mit nur einer einzigen Codetabelle codiert, so kann der Abstand der Rasterpunkte einfach erfaßt werden, indem den Seiteninformationen des Bitstroms entnommen wird, mit welcher Codetabelle codiert wurde. Je nach beschriebener Codierung ist der Abstand dann beispielsweise die Länge des längsten Codeworts dieser Tabelle, die im Codierer fest eingestellt sein könnte. Ist der Abstand die Länge des tatsächlich auftretenden längsten Codeworts in einem Teil des Bitstroms, dem eine Codetabelle zugeordnet ist, so wird derselbe mittels der Seiteninformationen, die dem Bitstrom zugeordnet sind, dem Decodierer mitgeteilt, usw.

Der Decodierer führt eine Umsortierung der Prioritätscodewörter und auch der Nicht-Prioritätscodewörter durch, indem er z. B. einen Zeiger auf den codierten Bitstrom anwendet. Ist dem Decodierer der Rasterabstand bekannt, so kann derselbe bei frequenzmäßig linearer Anordnung der Prioritätscodewörter zu einem Rasterpunkt springen und das dort beginnende Codewort einlesen. Ist das Einlesen eines Codeworts beendet, so springt der Zeiger zu dem nächsten Rasterpunkt und wiederholt den beschriebenen Vorgang. Sind alle Prioritätscodewörter eingelesen, so befinden sich im Bitstrom noch die Nicht-Prioritätscodewörter. Wurde eine jeweils lineare Anordnung der Prioritätscodewörter bzw. der Nicht-Prioritätscodewörter im Bitstrom gewählt, so sind die Nicht-Prioritätscodewörter für sich bereits linear mit der Frequenz angeordnet und können ohne weitere Umsortierung wieder decodiert und rücktransformiert werden.

Wurde einer Codierung nach dem dritten bzw. vierten Aspekt der vorliegenden Erfindung gewählt, so können Scramble-Informationen entweder als Seiteninformationen übertragen werden, oder eine Scrambleverteilung ist a priori festgelegt und damit auch dem Decodierer von vorneherein bekannt. Bezüglich des vierten Aspekts gelten dieselben Dinge. Es besteht immer die Möglichkeit, eine Verteilung fest zu vereinbaren oder variabel zu gestalten und dann dem Decodierer über Seiteninformationen mitzuteilen.

Im Nachfolgenden wird auf eine vorteilhafte Bestimmung und Handhabung der Prioritätscodewörter eingegangen. Nach Festlegen eines Rasters für einen codierten Bitstrom, durch Bestimmen des Rasterpunktabstandes bei Verwendung einer einzigen Codetabelle bzw. der Rasterpunktabstände bei Verwendung mehrerer Codetabellen, müssen die Prioritätscodewörter in das Raster positioniert werden, derart, daß der Beginn jedes Prioritätscodeworts mit einem Rasterpunkt zusammenfällt.

Gemäß einem bevorzugten Ausführungsbeispiel der Erfindung wird dieses Positionieren derart durchgeführt, daß Codewörter aus einer Art Sortiertabelle sequentiell in das gewissermaßen leere Raster einsortiert werden. Begonnen wird dabei mit dem ersten Codewort der Sortiertabelle. Durch Einsortieren der Codewörter in die Sortiertabelle kann daher Einfluß auf die Prioritätscodewörter genommen werden, wobei Prioritätscodewörter immer die Codewörter der Sortiertabelle sind, die im Raster Platz haben, d. h. für die Rasterpunkte vorhanden sind. Für Codewörter aus der Sortiertabelle, für die keine Rasterpunkte mehr vorhanden sind, bleibt keine andere Möglichkeit, als dieselben in die noch freien Plätze des Bitstroms einzusetzen. Diese Codewörter aus der Sortiertabelle sind somit keine Prioritätscodewörter im Sinne dieser Erfindung.

Die Anzahl der Prioritätscodewörter wird dabei nicht vorher bestimmt. Es werden solange Prioritätscodewörter geschrieben, bis der zur Verfügung stehende Speicher für den codierten Bitstrom voll ist, d. h. bis kein weiteres Prioritätscodewort mehr geschrieben werden kann. Die Größe des Speichers bestimmt sich aus der Gesamtanzahl der für die spektralen Daten zuvor verwendeten Bits, d. h. durch die Rasterung werden keine zusätzlichen Bits benötigt. Der Speicher ist also durch die Anzahl der Codewörter begrenzt, damit die Codiereffizienz aufgrund der Rastereinordnung nicht abfällt. Selbstverständlich könnten alle Codewörter auf Rasterpunkte plaziert werden, um dieselben fehlerrobust zu machen. Dies würde jedoch zu einer erheblichen Abnahme der Codiereffizienz führen, da die zwischen den Rasterpunkten freibleibenden Bits unbenutzt sind.

Ein Ausführungsbeispiel bezieht sich auf die Bestimmung der Prioritätscodewörter, d. h. der Codewörter, die Spektralwerte darstellen, die im Vergleich zu anderen Spektralwerten psychoakustisch bedeutsam sind. Eine psychoakustisch bedeutsame Spektrallinie ist beispielsweise eine Spektrallinie, die mehr Energie als eine andere Spektrallinie enthält. Allgemein kann gesagt werden, daß je mehr Energie eine Spektrallinie enthält, umso wichtiger dieselbe ist. Daher ist es einerseits wichtig, daß Spektrallinien mit hoher Energie nicht gestört sind, andererseits ist es genau so wichtig, daß Spektrallinien mit hoher Energie aufgrund von Fehlern nicht entstehen.

Bisher wurde davon ausgegangen, daß sich die Spektrallinien mit hoher Energie vorzugsweise im unteren Teil des Spektrums befinden. Dies stimmt in vielen Fällen, in manchen aber auch nicht. Ein Ausführungsbeispiel übergeht diese Annahme, indem sie einen implizit vorhandenen Indikator benutzt, um die Energie der in einem Codewort codierten Spektrallinie bzw. Spektrallinien, wenn mehrere Spektrallinien in einem Codewort codiert sind, abzuschätzen.

Dieser Indikator ist das verwendete Codebuch bzw. die verwendete Codetabelle, welche beispielsweise eine Huffman-Code-Tabelle sein kann. Im AAC-Standard werden beispielsweise elf Tabellen verwendet. Die Wertebereiche dieser Tabellen unterscheiden sich wesentlich. Die maximalen Absolutwerte der Tabellen 1 bis 11 stellen sich folgendermaßen dar:
1; 1; 2; 2; 4; 4; 7; 7; 12; 12; 8191.

Aufgrund dieser unterschiedlichen Wertebereiche ist dort der maximale Fehler tabellenabhängig. Er beträgt unter Berücksichtigung des Vorzeichens für jede Tabelle, das entweder in der Tabelle explizit vorhanden ist oder außerhalb der Tabelle mit übertragen wird, das zweifache des genannten Absolutwerts. Erfindungsgemäß wird die Bestimmung der Prioritätscodewörter anhand der verwendeten Codetabelle durchgeführt, wobei der Indikator der höhchste Absolutwert und implizit die Codetabellennummer ist. Als erstes werden Codewörter berücksichtigt, deren Codetabelle den größten Wertebereich hat. Dann folgen Codewörter, deren Codetabelle den zweitgrößten Wert hat, usw. Beim Beispiel des AAC-Standards wird somit als erstes die Tabelle 11 berücksichtigt, gefolgt von Tabelle 9 und 10, bis schließlich die Tabelle 1 und 2 mit der geringsten Priorität folgt. Prioritätscodewörter, die an Rasterpunkten plaziert werden, sind somit die Codewörter in der Sortiertabelle, für die Rasterpunkte vorhanden sind.

Vorteilhaft bei dieser Bestimmung der Codewörter ist die Tatsache, daß keine zusätzlichen Informationen für den Decodierer übertragen werden müssen, da die verwendeten Tabellen bereits in den Seiteninformationen übertragen werden und der Decodierer aus diesen Informationen die während der Übertragung verwendete Codewortreihenfolge bestimmen kann.

Ein weiteres Ausführungsbeispiel bezieht sich auf die Verwendung von kurzen Abtastfenstern oder "Short Windows" im Gegensatz zu langen Fenstern zur Transformation von zeitdiskreten Abtastwerten des Audiosignals in den Frequenzbereich, um Spektralwerte zu erhalten, die das Audiosignal darstellen. Im AAC-Standard sind ebenso wie im Standard Layer 3 auch kurze Abtastfenster ("Short Windows") definiert. Im Falle kurzer Fenster werden statt einer langen MDCT mehrere kurze MDCTs verwendet.

Beim AAC-Standard wird beispielsweise statt einer MDCT mit 1024 Ausgangswerten eine Gruppe von acht MDCTs mit jeweils 128 Ausgangswerten verwendet. Hierdurch wird die zeitliche Auflösung des Codierers zu Lasten der Frequenzauflösung erhöht. Im allgemeinen werden kurze Fenster bei transienten Signalen verwendet. Werden kurze Fenster verwendet, ergeben sich z. B. bei AAC acht zeitlich aufeinanderfolgende komplette Spektren, d. h. acht Sätze von Spektralwerten, wobei jeder Satz von Spektralwerten das gesamte Spektrum umfaßt. Im Gegensatz zu den langen Fenstern ist jedoch der Abstand zwischen den Spektralwerten ebenfalls achtmal so groß. Dies stellt die verringerte Frequenzauflösung dar, der Codierer hat jedoch hierdurch eine höhere Zeitauflösung.

Beim AAC-Standard wird eine Gruppierung ("Grouping") durchgeführt, d. h. es werden aus den acht Spektren Gruppen gebildet. Für jede dieser Gruppen existiert ein Satz von Skalenfaktoren. Im einfachsten Fall enthält jede Gruppe nur ein Fenster. In diesem Fall müssen acht Skalenfaktorensätze übertragen werden. Um eine stärkere Kompression zu ermöglichen, wird im AAC-Standard in der Regel unter Beachtung psychoakustischer Anforderungen eine Zusammenfassung mehrerer Fenster in eine Gruppe durchgeführt. Hierdurch wird die Anzahl der zu übertragenden Skalenfaktoren verringert, um eine bessere Datenkompression zu erreichen. Die Spektraldaten werden gruppenweise sequentiell übertragen, d. h. in einen codierten Bitstrom geschrieben. Innerhalb der Gruppen wird ein sogenanntes skalenfaktorbandweises "Interleaving", d. h. eine skalenfaktorbandweise Verschachtelung durchgeführt.

Dies sei anhand folgenden Beispiels dargestellt. Im Beispiel wurde eine Gruppierung in drei Gruppen durchgeführt. Die erste Gruppe enthält zwei Fenster, die zweite Gruppe enthält drei Fenster und die dritte Gruppe enthält ebenfalls drei Fenster. Jedes Spektrum weißt 12 Skalenfaktorbänder auf. Die Gruppierung stellt sich dann folgendermaßen dar:
1. Gruppe, 1. Fenster, 1. Skalenfaktorband
1. Gruppe, 2. Fenster, 1. Skalenfaktorband
1. Gruppe, 1. Fenster, 2. Skalenfaktorband
1. Gruppe, 2. Fenster, 2. Skalenfaktorband
...
1. Gruppe, 2. Fenster, 12. Skalenfaktorband
2. Gruppe, 3. Fenster, 1. Skalenfaktorband
2. Gruppe, 4. Fenster, 1. Skalenfaktorband
2. Gruppe, 5. Fenster, 1. Skalenfaktorband
2. Gruppe, 3. Fenster, 2. Skalenfaktorband
...

Diese Anordnung ist für die Vorsortierung bzw. Einsortierung von Codewörtern aus der Sortiertabelle in das Raster ungünstig, da bei Durchführung einer sequentiellen Einsortierung das gesamte Spektrum der ersten Gruppen geschützt würde, das der letzten hingegen komplett ungeschützt wäre. Daher wird im Fall von kurzen Fenstern eine Vorsortierung gemäß dem Ausführungsbeispiel durchgeführt. Hierbei wird im Falle des AAC-Standards die Gruppierung sowie die skalenfaktorbandweise Betrachtung aufgehoben. Es wird eine erneute Vorsortierung durchgeführt, und zwar in Einheiten oder "Units" von Spektrallinien.

Bei einem bevorzugten Ausführungsbeispiel erhält jede Unit 4 Spektrallinien. Bei dem AAC-Standard enthält somit jedes Fenster 32 Units, was 128 Spektrallinien entspricht. Die Anordnung der Spektraldaten geschieht folgendermaßen:
1. Fenster, 1. Unit
2. Fenster, 1. Unit
...
8. Fenster, 1. Unit
1. Fenster, 2. Unit
2. Fenster, 2. Unit
...
8. Fenster, 2. Unit
1. Fenster, 3. Unit
...

Durch diese Vorsortierung wird sichergestellt, daß die einzelnen Spektralbereiche aller Fenster in Nachbarschaft zueinander liegen, d. h. daß niedrige Spektralwerte entsprechend der Frequenz aus den einzelnen Sätzen von Spektralwerten in den vorderen Bereich der Sortiertabelle vor den Spektralwerten mit hoher Frequenz geschrieben werden. Sind besonders die Spektralwerte im unteren Spektralbereich psychoakustisch bedeutsam, dann kann ausgehend von dieser beschriebenen Vorsortierung in der Sortiertabelle das Einsortieren aus derselben in das Raster erfolgen. Für diese Vorsortierung der Codewörter, d. h. die Bestimmung der Prioritätscodewörter, sind keine zusätzlichen Informationen zu übertragen, da der Decodierer anhand der Seiteninformationen genau weiß, daß in diesem Block oder "Frame" kurze Fenster verwendet wurden, und der Sortieralgorithmus im Codierer, um die "Units" zu erzeugen, immer fest ist und daher fest in den Decodierer einprogrammiert ist.

An dieser Stelle sei darauf hingewiesen, daß das Vorsortieren von Codewörtern in eine Sortiertabelle dem Bestimmen der Prioritätscodewörter entspricht, da diese Tabelle an sich festlegt, ob Codewörter mit sehr großer Wahrscheinlichkeit an Rasterpunkte geschrieben werden können. Die Codewörter, die mit sehr großer Wahrscheinlichkeit an Rasterpunkten positioniert werden können, d. h. die Prioritätscodewörter, sind nämlich die Codewörter am Beginn bzw. im vorderen oder oberen Bereich der Sortiertabelle.

In Abweichung dazu l wird diese Vorsortierung nicht mittels einer Sortiertabelle geschehen, sondern dieselbe kann ebenfalls durch eine Indizierung durchgeführt werden, derart, daß eine Indizierung der einzelnen Codewörter erfolgt, wobei diese Indizierung die Reihenfolge festlegt, in der die indizierten Codewörter in den Bitstrom geschrieben werden.

Aus dem AAC-Standard ist bekannt, daß einige Codetabellen zweidimensional bzw. vierdimensional sind, d. h., daß ein Codewort zwei bzw. vier Spektralwerte codiert. Daher ist es günstig, vier Spektrallinien oder ein Vielfaches hiervon zu einer Unit zu gruppieren, da so Codewörter, die den gleichen Frequenzbereich codieren, unmittelbar aufeinanderfolgend sortiert werden könnnen. Die Anzahl der Spektrallinien aus einer Unit ist daher vorzugsweise durch die verschiedenen Dimensionen der Codetabellen teilbar, d. h. die Anzahl der Linien pro Unit muß ein gemeinsames Vielfaches der Anzahl der Linien pro Codewort und am besten das kleinste gemeinsame Vielfache sein.

Eine Effizienzsteigerung kann durch die Kombination zweier beschriebener Ausführungsbeispiele erreicht werden. Wenn im Falle von kurzen Fenstern die erfindungsgemäße Umsortierung in Units ausgeführt worden ist, so kann die Prioritätscodewortbestimmung mittels des Codetabellen-Indikators nachgeschaltet werden, derart, daß das Ergebnis der Unit-Umsortierung noch einmal umsortiert wird, um sicherzustellen, daß die Codewörter aus höheren Codetabellen Prioritätscodewörter werden, die an festen Rasterpunkten positioniert werden, um eine hohe Fehlersicherheit zu erreichen. Diese Kombination ist nicht zwingend notwendig, liefert aber die besten Ergebnisse.

## Patentansprüche

1. Eine Vorrichtung zum Decodieren eines Bitstroms, wobei der Bitstrom Wörter (1, 2, 6, 7a) mit unterschiedlichen Längen aus einer Codetabelle (n) und, als Seiteninformationen, die Länge des längsten tatsächlich auftretenden Codeworts in einem Block (0) aufweist, **gekennzeichnet durch**:
einen Decodierer zum Decodieren des Bitstroms unter Verwendung der Codetabelle, wobei der Decodierer wirksam ist, um zu erfassen, ob ein aus dem Bitstrom extrahiertes Codewort länger als die Länge des längsten tatsächlich auftretenden Codeworts ist und deshalb ein falsches Codewort ist, wobei eine Gegenmaßnahme ergriffen wird, wenn ein derartiges falsches Codewort erfasst wird.

2. Eine Vorrichtung gemäß Anspruch 1, bei der als Gegenmaßnahme ein Ausblenden oder ein Verschleiern des falschen Codeworts durchgeführt wird.

3. Eine Vorrichtung gemäß Anspruch 1 oder Anspruch 2, bei der der Bitstrom ein codiertes Audiosignal darstellt, und bei der ein langes Codewort einem Spektralwert des Audiosignals entspricht, das im Vergleich zu einem vergleichsweise kurzen Codewort, das einem Spektralwert entspricht, der eine vergleichsweise geringe Energie aufweist, eine hohe Energie aufweist.

4. Eine Vorrichtung gemäß einem der vorhergehenden Ansprüche, bei der der Bitstrom ein codiertes Audiosignal darstellt, wobei der Bitstrom Codewörter mit unterschiedlichen Längen aus einer Codetabelle enthält und ein Raster mit äquidistanten Rasterpunkten (10, 12, 14) aufweist, wobei die Codewörter Prioritätscodewörter umfassen, die bestimmte Spektralwerte eines Blocks von Spektralwerten darstellen, die im Vergleich zu anderen Spektralwerten psychoakustisch bedeutsam sind, wobei der Block von Spektralwerten ein Spektrum eines Blocks zeitlicher Abtastwerte des Audiosignals darstellt, und wobei Prioritätscodewörter mit Rasterpunkten ausgerichtet sind, so dass der Beginn eines Prioritätscodeworts, das einen Spektralwert des Blocks von Spektralwerten darstellt, mit einem Rasterpunkt zusammenfällt, und dass der Beginn eines anderen Prioritätscodeworts, das einen anderen Spektralwert des Blocks von Spektralwerten darstellt, mit einem anderen Rasterpunkt zusammenfällt, wobei die Vorrichtung ferner folgende Merkmale aufweist:
eine Einheit zum Erfassen des Abstands (D1) zwischen zwei benachbarten Rasterpunkten unter Verwendung der Länge des längsten tatsächlich auftretenden Codeworts, die in dem Bitstrom als Seiteninformationen übertragen wird, und zum Setzen des Abstands gleich der Länge; und
eine Einheit zum Lesen der Prioritätscodewörter, die mit den Rasterpunkten ausgerichtet sind, in dem codierten Bitstrom, wobei der Beginn eines Prioritätscodeworts mit einem Rasterpunkt zusammenfällt, so dass die Prioritätscodewörter unter Verwendung einer zugeordneten Codetabelle decodiert werden können, um decodierte Spektralwerte zu erhalten, und in den Zeitbereich rücktransformiert werden, um ein decodiertes Audiosignal zu erhalten.

5. Eine Vorrichtung gemäß Anspruch 4, bei der der codierte Bitstrom Codewörter mit unterschiedlichen Längen aus zumindest zwei Codetabellen enthält, und ein Raster mit zumindest zwei Gruppen von äquidistanten Rasterpunkten (10, 12, 14 und 14, 16, 18) aufweist, und, als Seiteninformationen, für einen Abschnitt, die Länge des längsten tatsächlich auftretenden Codeworts des Spektralabschnitts, wobei die Vorrichtung ferner eine Einheit zum Identifizieren der einem Spektralabschnitt zugeordneten Codetabelle aufweist,
wobei die Einheit zum Erfassen ferner wirksam ist, um den Abstand zwischen zwei Rasterpunkten für dem Spektralabschnitt zugeordneten Codewörtern gleich der Länge des längsten tatsächlich auftretenden Codeworts des Spektralabschnitts zu setzen, und
wobei beim Decodieren die Prioritätscodewörter eines Spektralabschnitts mit der entsprechenden zugeordneten Codetabelle decodiert werden, und
wobei der Decodierer ferner wirksam ist, um für einen Abschnitt, die einem Abschnitt zugeordneten Codewörter zu erfassen, ob ein dem Abschnitt zugeordnetes Codewort länger als die Länge des längsten tatsächlich auftretenden Codeworts ist.

6. Ein Verfahren zum Decodieren eines Bitstroms, wobei der Bitstrom Codewörter (1, 2, 6, 7a) mit unterschiedlichen Längen aus einer Codetabelle (n) und, als Seiteninformationen, die Länge des längsten tatsächlich auftretenden Codeworts in einem Block (0) aufweist, mit folgenden Schritten:
Decodieren des Bitstroms unter Verwendung der Codetabelle, wobei im Schritt des Decodierens erfasst wird, ob ein aus dem Bitstrom extrahiertes Codewort länger als die Länge des längsten tatsächlich auftretenden Codeworts ist und deshalb ein falsches Codewort ist; und
Ergreifen einer Gegenmaßnahme, wenn ein derartiges falsches Codewort erfasst wird.

7. Ein Verfahren gemäß Anspruch 6, bei dem der Bitstrom ein codiertes Audiosignal darstellt, wobei der Bitstrom Codewörter mit unterschiedlichen Längen aus einer Codetabelle enthält, und ein Raster mit äquidistanten Rasterpunkten (10, 12, 14) aufweist, wobei die Codewörter Prioritätscodewörter umfassen, die bestimmte Spektralwerte eines Blocks von Spektralwerten darstellen, die im Vergleich zu anderen Spektralwerten psychoakustisch bedeutsam sind, wobei der Block von Spektralwerten ein Spektrum eines Blocks zeitlicher Abtastwerte des Audiosignals darstellt, und wobei Prioritätscodewörter mit Rasterpunkten ausgerichtet sind, so dass der Beginn eines Prioritätscodeworts, das den Spektralwert des Blocks von Spektralwerten darstellt, mit einem Rasterpunkt zusammenfällt und der Beginn eines anderen Prioritätscodeworts, das einen anderen Spektralwert des Blocks von Spektralwerten darstellt, mit einem anderen Rasterpunkt zusammenfällt, wobei das Verfahren ferner die folgenden Schritte aufweist:
Erfassen des Abstands (D1) zwischen zwei benachbarten Rasterpunkten unter Verwendung der Länge des längsten tatsächlich auftretenden Codeworts, die in dem Bitstrom als Seiteninformationen übertragen wird, und Setzen des Abstands gleich der Länge; und
Umsortieren der Prioritätscodewörter, die mit den Rasterpunkten ausgerichtet sind, in dem codierten Bitstrom, derart, dass eine lineare Anordnung mit der gleichen Frequenz erhalten wird, wobei der Beginn eines Prioritätscodeworts mit einem Rasterpunkt zusammenfällt, so dass die Prioritätscodewörter unter Verwendung einer zugeordneten Codetabelle decodiert werden können, um decodierte Spektralwerte zu erhalten, und in den Zeitbereich rücktransformiert werden können, um ein decodiertes Audiosignal zu erhalten.

8. Ein Verfahren gemäß Anspruch 7,
bei dem der codierte Bitstrom Codewörter mit unterschiedlichen Längen aus zumindest zwei Codetabellen enthält, und ein Raster mit zumindest zwei Gruppen äquidistanter Rasterpunkte (10, 12, 14 und 14, 16, 18) aufweist, und, als Seiteninformationen, für einen Abschnitt, die Länge des längsten tatsächlich auftretenden Codeworts des Spektralabschnitts, wobei die Vorrichtung ferner eine Einheit zum Identifizieren der einem Spektralabschnitt zugeordneten Codetabelle aufweist,
wobei bei dem Schritt des Erfassens des Abstands der Abstand zwischen zwei Rasterpunkten für dem Spektralabschnitt zugeordnete Codewörter gleich der Länge des längsten tatsächlich auftretenden Codeworts des Spektralabschnitts gesetzt wird, und
wobei beim Decodieren die Prioritätscodewörter eines Spektralabschnitts mit der entsprechenden zugeordneten Codetabelle decodiert werden, und
wobei die Teilschritte des Erfassens und Ergreifens für einen Abschnitt unter Verwendung der Länge des längsten tatsächlich auftretenden Codeworts für den jeweiligen Abschnitt, die in dem Bitstrom als Seiteninformationen enthalten ist, durchgeführt werden.

## Claims

1. An apparatus for decoding a bit stream, the bit stream comprising words (1, 2, 6, 7a) of different lengths from a code table (n) and, as side information, the length of the longest actually occurring code word in a block (0), **characterized by**:
a decoder for decoding a bit stream, using the code table, the decoder being operative to detect whether a code word extracted from the bit stream is longer than the length of the longest actually occurring code word and therefore is a wrong code word, wherein a countermeasure is taken if such a wrong code word is detected.

2. An apparatus according to claim 1, wherein fading out or disguising the wrong code word is performed as a countermeasure.

3. An apparatus according to claim 1 or claim 2, wherein the bit stream represents an encoded audio signal, and wherein a long code word corresponds to a spectral value of the audio signal having high energy as compared with a comparably short code word corresponding to a spectral value having comparably low energy.

4. An apparatus according to one of the preceding claims, wherein the bit stream represents an encoded audio signal, wherein the bit stream contains code words of different lengths from a code table and comprises a raster with equidistant raster points (10, 12, 14), wherein the code words include priority code words representing certain spectral values of a block of spectral values that are psycho-acoustically important as compared with other spectral values, wherein the block of spectral values represents a spectrum of a block of time samples of the audio signal, and wherein priority code words are aligned with raster points so that the beginning of a priority code word representing a spectral value of the block of spectral values coincides with a raster point, and that the beginning of another priority code word representing another spectral value of the block of spectral values coincides with another raster point, wherein the apparatus further comprises:
a unit for detecting the distance (D1) between two adjacent raster points using the length of the longest actually occurring code word transmitted as side information in the bit stream, and for setting the distance equal to the length; and
a unit for reading the priority code words aligned with the raster points in the encoded bit stream,
wherein the beginning of a priority code word coincides with a raster point, so that the priority code words can be decoded using an associated code table to obtain decoded spectral values, and are transformed back into the time domain to obtain a decoded audio signal.

5. An apparatus according to claim 4, wherein the encoded bit stream contains code words of different lengths from at least two code tables and comprises a raster with at least two groups of equidistant raster points (10, 12, 14 and 14, 16, 18), and, as side information, for one portion, the length of the longest actually occurring code word of the spectral portion, wherein the apparatus further comprises a unit for identifying the code table associated with a spectral portion,
wherein the unit for detecting further is operative to set the distance between two raster points for code words associated with the spectral portion equal to the length of the longest actually occurring code word of the spectral portion, and
wherein, when decoding, the priority code words of a spectral portion are decoded with the corresponding associated code table, and
wherein the decoder further is operative to detect, for a portion, the code words associated with a portion, whether a code word associated with the portion is longer than the length of the longest actually occurring code word.

6. A method of decoding a bit stream, the bit stream comprising code words (1, 2, 6, 7a) of different lengths from a code table (n) and, as side information, the length of the longest actually occurring code word in a block (0), comprising:
decoding the bit stream, using the code table, wherein, in the step of decoding, it is detected whether a code word extracted from the bit stream is longer than the length of the longest actually occurring code word and therefore is a wrong code word; and
taking a countermeasure if such a wrong code word is detected.

7. A method according to claim 6, wherein the bit stream represents an encoded audio signal, wherein the bit stream contains code words of different lengths from a code table and comprises a raster with equidistant raster points (10, 12, 14), wherein the code words include priority code words representing certain spectral values of a block of spectral values that are psycho-acoustically important as compared with other spectral values, wherein the block of spectral values represents a spectrum of a block of temporal samples of the audio signal, and wherein priority code words are aligned with raster points, so that the beginning of a priority code word representing the spectral value of the block of spectral values coincides with a raster point, and the beginning of another priority code word representing another spectral value of the block of spectral values coincides with another raster point, wherein the method further comprises:
detecting the distance (D1) between two adjacent raster points, using the length of the longest actually occurring code word transmitted as side information in the bit stream, and setting the distance equal to the length; and
re-sorting the priority code words aligned with the raster points in the encoded bit stream such that a linear arrangement of the same frequency is obtained,
wherein the beginning of the priority code word coincides with a raster point, so that the priority code words can be decoded using an associated code table to obtain decoded spectral values, and can be transformed back into the time domain to obtain a decoded audio signal.

8. A method according to claim 7,
wherein the encoded bit stream contains code words of different lengths from at least two code tables and comprises a raster with at least two groups of equidistant raster points (10, 12, 14 and 14, 16, 18), and, as side information, for a portion, the length of the longest actually occurring code word of the spectral portion, wherein the apparatus further comprises a unit for identifying the code table associated with a spectral portion,
wherein, in the step of detecting the distance, the distance between two raster points for code words associated with the spectral portion is set equal to the length of the longest actually occurring code word of the spectral portion, and
wherein, when decoding, the priority code words of a spectral portion are decoded with the corresponding associated code table, and
wherein the sub-steps of detecting and taking are performed for a portion, using the length of the longest actually occurring code word for the respective portion, which is contained as side information in the bit stream.

## Revendications

1. Dispositif pour décoder un train binaire, le train binaire présentant des mots (1, 2, 6, 7a) de longueurs différentes d'un tableau de codes (n) et, comme informations latérales, la longueur du mot de code le plus long se présentant effectivement dans un bloc (0), **caractérisé par**:
un décodeur destiné à décoder le train binaire à l'aide du tableau de codes, le décodeur étant opérationnel pour détecter si un mot de code extrait du train binaire est plus long que la longueur du mot de code le plus long se présentant effectivement et est, de ce fait, un faux mot de code, une contre-mesure étant prise lorsqu'il est détecté un tel mot de code.

2. Dispositif selon la revendication 1, dans lequel est réalisé, comme contre-mesure, un effacement ou un masquage du faux mot de code.

3. Dispositif selon la revendication 1 ou la revendication 2, dans lequel le train binaire représente un signal audio codé, et dans lequel un mot de code long correspond à une valeur spectrale du signal audio, lequel présente, comparé à un mot de code comparativement court, qui correspond à une valeur spectrale présentant une énergie comparativement faible, une grande énergie.

4. Dispositif selon l'une des revendications précédentes, dans lequel le train binaire représente un signal audio codé, le train binaire contenant des mots de code de longueurs différentes d'un tableau de codes et présentant une trame à points de trame équidistants (10, 12, 14), les mots de code comprenant des mots de code de priorité qui représentent des valeurs spectrales déterminées d'un bloc de valeurs spectrales qui, comparé à d'autres valeurs spectrales, sont importantes du point de vue psycho-acoustique, le bloc de valeurs spectrales représentant un spectre d'un bloc de valeurs de balayage dans le temps du signal audio, et les mots de code de priorité étant alignés sur des points de trame, de sorte que le début d'un mot de code de priorité qui représente une valeur spectrale du bloc de valeurs spectrales coïncide avec un point de trame et que le début d'un autre mot de code de priorité qui représente une autre valeur spectrale du bloc de valeurs spectrales coïncide avec un autre point de trame, le dispositif présentant par ailleurs les caractéristiques suivantes:
une unité destinée à détecter la distance (D1) entre deux points de trame adjacents à l'aide de la longueur du mot de code le plus long se présentant effectivement qui est transmise comme informations latérales dans le train binaire, et à régler la distance égale à la longueur; et
une unité destinée à lire les mots de code de priorité qui sont alignés sur les points de trame dans le train binaire codé, le début d'un mot de code de priorité coïncidant avec un point de trame, de sorte que les mots de code de priorité puissent être décodés à l'aide d'un tableau de codes associé, pour obtenir des valeurs spectrales décodées, et soient à nouveau transformés au domaine du temps, pour obtenir un signal audio décodé.

5. Dispositif selon la revendication 4, dans lequel le train binaire codé contient des mots de code de longueurs différentes d'au moins deux tableaux de codes, et présente une trame avec au moins deux groupes de points de trame équidistants (10, 12, 14 et 14, 16, 18), et, comme informations latérales, pour un segment, la longueur du mot de code le plus long se présentant effectivement du segment spectral, le dispositif présentant par ailleurs une unité destinée à identifier le tableau de codes associé à un segment spectral,
l'unité destinée à détecter étant par ailleurs opérationnelle pour régler la distance entre deux points de trame pour les mots de code associés au segment spectral égale à la longueur du mot de code le plus long se présentant effectivement du segment spectral, et
lors du décodage, les mots de code de priorité d'un segment spectral étant décodés à l'aide du tableau de codes associé correspondant, et
le décodeur étant par ailleurs opérationnel pour détecter pour un segment les mots de code associés à un segment, pour savoir si un mot de code associé au segment est plus long que la longueur du mot de code le plus long se présentant effectivement.

6. Procédé pour décoder un train binaire, dans lequel le train binaire présente des mots de code (1, 2, 6, 7a) de longueurs différentes d'un tableau de codes (n) et présente, comme informations latérales, la longueur du mot de code le plus long se présentant effectivement dans un bloc (0), aux étapes suivantes consistant à:
décoder le train binaire à l'aide du tableau de codes, à l'étape de décodage étant détecté si un mot de code extrait du train binaire est plus long que la longueur du mot de code le plus long se présentant effectivement et est, de ce fait, un faux mot de code; et
prendre une contre-mesure lorsqu'un tel faux mot de code est détecté.

7. Procédé selon la revendication 6, dans lequel le train binaire représente un signal audio codé, le train binaire contenant des mots de code de longueurs différentes d'un tableau de codes et présente une trame à points de trame équidistants (10, 12, 14), les mots de code comprenant des mots de code de priorité qui représentent des valeurs spectrales déterminées d'un bloc de valeurs spectrales qui, comparé à d'autres valeurs spectrales, sont importantes du point de vue psycho-acoustique, le bloc de valeurs spectrales représentant un spectre d'un bloc de valeurs de balayage dans le temps du signal audio, et les mots de code de priorité étant alignés sur des points de trame, de sorte que le début d'un mot de code de priorité qui représente la valeur spectrale du bloc de valeurs spectrales coïncide avec un point de trame et que le début d'un autre mot de code de priorité qui représente une autre valeur spectrale du bloc de valeurs spectrales coïncide avec un autre point de trame, le procédé présentant par ailleurs les étapes suivantes consistant à:
détecter la distance (D1) entre deux points de trame adjacents à l'aide de la longueur du mot de code le plus long se présentant effectivement qui est transmise comme informations latérales dans le train binaire, et régler la distance égale à la longueur; et
retrier les mots de code de priorité qui sont alignés sur les points de trame dans le train binaire codé, de sorte que soit obtenu un aménagement linéaire à la même fréquence, le début d'un mot de code de priorité coïncidant avec un point de trame, de sorte que les mots de code de priorité puissent être décodés à l'aide d'un tableau de codes associé, pour obtenir des valeurs spectrales décodées, et puissent à nouveau être transformés au domaine du temps, pour obtenir un signal audio décodé.

8. Procédé selon la revendication 7,
dans lequel le train binaire codé contient des mots de code de longueurs différentes d'au moins deux tableaux de codes, et présente une trame avec au moins deux groupes de points de trame équidistants (10, 12, 14 et 14, 16, 18), et, comme informations latérales, pour un segment, la longueur du mot de code le plus long se présentant effectivement du segment spectral, le dispositif présentant par ailleurs une unité destinée à identifier le tableau de codes associé à un segment spectral,
à l'étape de détection de la distance, la distance entre deux points de trame pour les mots de code associés au segment spectral étant réglée égale à la longueur du mot de code le plus long se présentant effectivement du segment spectral, et
lors du décodage, les mots de code de priorité d'un segment spectral étant décodés à l'aide du tableau de codes associé correspondant, et
les étapes partielles consistant à détecter et saisir pour un segment, à l'aide de la longueur du mot de code le plus long se présentant effectivement pour le segment respectif qui est contenue comme informations latérales dans le train binaire, étant réalisées.
